# EUROPEAN PATENT APPLICATION

(11) **EP 4 845 380 A1**
(43) Date of publication of application: **25.11.2026**
(21) Application number: 26179577.7
(22) Date of filing: 19.05.2026
(51) Int. Cl.: H10W 74/10, H10W 42/00, H10W 70/09, H10W 72/00, H10P 72/70, H10W 40/25, H10W 74/01

(54) **POWER INTEGRATED CIRCUIT DEVICE PACKAGE AND METHOD OF MAKING**

(30) Priority: 21.05.2025 US 202519214297
(71) Applicant: STMicroelectronics International N.V., 1228 Plan-les-Ouates, Geneva (CH)
(72) Inventor: LUAN, Jing-En, 544559 SINGAPORE (SG)
(74) Representative: Cabinet Beaumont

(57) **Abstract**

An integrated circuit device package includes a support substrate with a conductive layer. An integrated circuit device having a backside device terminal is mounted to the conductive layer. A first insulating ring wall at the conductive layer surrounds an area of the conductive layer. A second insulating ring wall at a frontside of the integrated circuit device surrounds an area of a second device terminal. Metal material filling a volume of a reservoir delimited by each of the first and second insulating ring walls provides first and second package contacts for electrical coupling to the first and second device terminals, respectively. An encapsulating body encapsulates the integrated circuit device and the first and second insulating ring walls. A front surface of the encapsulating body is coplanar with distal ends of the first and second insulating ring walls and distal ends of the first and second package contacts.

## Description

### TECHNICAL FIELD

The present disclosure generally relates to integrated circuit packaging and, in particular, to a power integrated circuit device package and a method of making such a power integrated circuit device package.

### BACKGROUND

A power integrated circuit device package or module of conventional design typically uses clip bonding, wire bonding or ribbon bonding in support of making electrical connections to the bonding or terminal pads (such as the power transistor source or gate terminals) of the integrated circuit device. As a result, the package or module can have a large size and exhibit a high inductance. There are also concerns with such packages with respect to providing effective heat dispersion. Improvements in power integrated circuit device package or module design and methods of manufacture are needed in order to support package miniaturization, integration and improved reliability (in consumer and automotive products, for example).

### SUMMARY

In an embodiment, an integrated circuit device package comprises: a support substrate having a front surface with a conductive layer; an integrated circuit device having a first device terminal at a backside mounted to the conductive layer of the support substrate and having a second device terminal at a frontside; a first insulating ring wall mounted to the conductive layer of the support substrate surrounding an area of the conductive layer; a second insulating ring wall mounted to the frontside of the integrated circuit device surrounding an area of the second device terminal; metal material filling a volume of a reservoir delimited by each of the first and second insulating ring walls to provide a first package contact for electrical coupling to the first device terminal and a second package contact for electrical coupling to the second device terminal; and an encapsulating body which encapsulates the integrated circuit device and the first and second insulating ring walls, wherein a front surface of the encapsulating body is coplanar with distal ends of the first and second insulating ring walls and distal ends of the first and second package contacts.

In an embodiment, a circuit comprises: a printed circuit board having first and second circuit pads; and the integrated circuit device package as described above mounted to the printed circuit board with the first and second package contacts soldered to the first and second circuit pads, respectively. A heatsink may be mounted to a further conductive layer at a back surface of the support substrate.

In an embodiment, a method comprises: mounting an integrated circuit device having a first device terminal at a backside to a conductive layer at a front surface of a support substrate; controlling deposit of an insulating material to form a first insulating ring wall at the conductive layer of the support substrate surrounding an area of the conductive layer and form a second insulating ring wall at a frontside of the integrated circuit device surrounding an area of a second device terminal; controlling deposit of a conductive material to fill a volume of a reservoir delimited by each of the first and second insulating ring walls to form corresponding first and second contacts electrically coupled to the first and second device terminals, respectively; molding an encapsulation material to encapsulate the integrated circuit device and the first and second insulating ring walls within an encapsulating body.

In an embodiment, a grinding operation is performed on the encapsulating material to form the coplanar front surface of the encapsulating body, distal ends of the first and second insulating ring walls and distal ends of the first and second package contacts.

In an embodiment, a cutting operation is performed through the encapsulating material to singulate an integrated circuit device package.

The controlling deposit may, for example, be accomplished using one or more of a dispensing operation, an additive manufacturing operation, or a printing operation.

The support substrate may comprise a direct bond copper (DBC) substrate.

The support substrate may comprise an active metal brazing substrate (AMB) substrate.

The integrated circuit device may comprise a power integrated circuit device such as, for example, a MOSFET device, an IGBT device, a GaN device, a diode device.

In an embodiment, the first and second insulating ring walls are made of a glue material.

In an embodiment, the encapsulating body is made of a resin material.

### BRIEF DESCRIPTION OF THE DRAWINGS

For a better understanding of the embodiments, reference will now be made by way of example only to the accompanying figures in which:
Figure 1 is a cross-sectional view of a power integrated circuit device package;
Figure 2 is a cross-sectional view of a power integrated circuit device package;
Figures 3A-3I show steps of a method of manufacturing the package of Figures 1 and 2;
Figures 4A-4K show steps of a method of manufacturing the package of Figures 1 and 2; and
Figure 5 shows the mounting of the power integrated circuit device package of Figure 2 to a printed circuit board.

### DETAILED DESCRIPTION

In the following description, certain specific details are set forth in order to provide a thorough understanding of various aspects of the disclosed subject matter. However, the disclosed subject matter may be practiced without these specific details. In some instances, well-known structures and methods of semiconductor processing comprising embodiments of the subject matter disclosed herein have not been described in detail to avoid obscuring the descriptions of other aspects of the present disclosure.

It will be noted that the drawings are not necessary presented to scale in order that structural features of the device and method of manufacture can be better explained and illustrated.

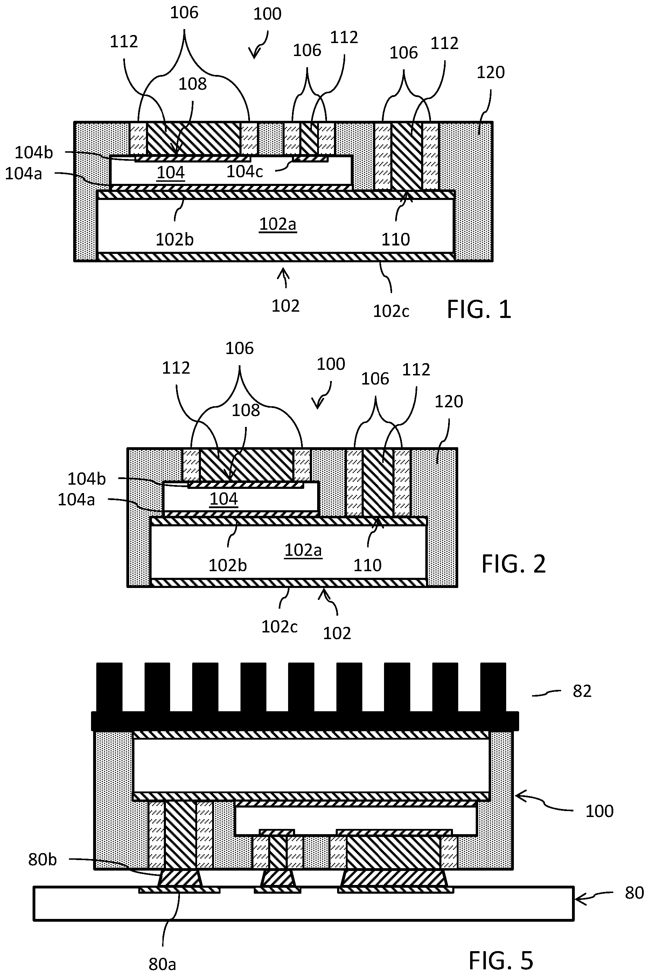

Reference is now made to Figure 1 which shows a cross-sectional view of a power integrated circuit device package 100.

The package 100 includes a support substrate 102 comprising, for example, a direct bond copper (DBC) substrate or an active metal brazing (AMB) substrate. The substrate 102 includes a ceramic base layer 102a having a conductive layer 102b at the front surface and a conductive layer 102c at the back surface. In a DBC substrate configuration, the conductive layers 102b, 102c are copper layers bonded to the front and back surfaces, respectively, using a high temperature oxidation process. In an AMB substrate configuration, the conductive layers 102b, 102c are metal foils soldered to the ceramic base layer 102a using solder paste at a high temperature under vacuum. DBC and AMB substrate configurations and methods of manufacture are well-known to those skilled in the art. In an example configuration, the conductive layer 102b at the front surface may be a patterned layer forming an electrical circuit including traces and pads, while the conductive layer 102c at the back surface is left as a plane structure providing complete or substantially complete coverage over the back surface.

A power integrated circuit device 104 is mounted to the support substrate 102. The power integrated circuit device 104 may, for example, comprise a MOSFET device, an IGBT device, a GaN device, a diode device, etc., which must handle a large current and/or voltage. As a non-limiting example, Figure 1 shows the power integrated circuit device 104 as three-terminal transistor device having a drain terminal 104a at the backside of the device 104, a source terminal 104b at the frontside of the device 104 and a gate terminal 104c at the frontside of the device 104. In a more general description, the device 104 is understood to have at least one terminal at the backside of the device 104 and at least one terminal at the frontside of the device 104, with the device providing a current conduction path between the at least one frontside terminal and the at least one backside terminal. The terminal 104a at the backside of the device 104 is attached to the conductive layer 102b at the front surface of the substrate 102 using a suitable conductive adhesive material (not explicitly shown) such as, for example, sintering glue or solder. Cross-sectional details of the power integrated circuit device 104 (such as the semiconductor layer with doped regions, insulating regions and surface regions associated with front end of line (FEOL) manufacturing, as well as the interconnect layer with one or more metallization levels associated with back end of line (BEOL) manufacturing) are omitted from the illustrated figures as such structures are well-known to those skilled in the art and are not critical to an understanding of the overall package and its method of manufacture. Suffice it to say that the drain terminal 104a at the backside of the device 104 is provided in contact with the backside of the semiconductor layer for the integrated circuit device 104 and the source terminal 104b and gate terminal 104c at the frontside of the device 104 are provided in connection with the interconnect layer for the integrated circuit device 104.

At the frontside of the device 104 and at the front surface of the substrate 102, ring walls 106 made of insulating material are formed surrounding an area 108 each terminal 104b, 104c at the frontside of the device 104 and surrounding an area 110 of the conductive layer 102b at the front surface of the substrate 102. In plan (top) view, the ring walls 106 may have any suitable closed shape such as a circle, oval, square, rectangle, etc. In an implementation, the closed shape of the ring wall 106 may correspond, generally or substantially, to the perimeter outline shape of the terminal 104b, 104c. The insulating material of the ring walls 106 may, for example, comprise a glue material which is dispensed in liquid form (for example, using printing, dispensing and/or using additive manufacturing techniques) at the desired location and then suitably cured. The area 108 each terminal 104b, 104c which is surrounded by the ring wall 106 is smaller, in a preferred implementation, than the overall area of the terminal 104b, 104 itself. The ring wall 106 has a thickness sufficient to provide lateral structure strength in support so that the wall does not collapse or substantially deform during subsequent process steps for filling and encapsulating as discussed below.

Each ring wall 106, with the underlying terminal 104b, 104c or conductive layer 102b, delimits an open top reservoir having a volume which is filled by a conductive material in connection with forming a package contact 112. The conductive material filling the volume of the reservoir within each ring wall 106 may, for example, comprise a solder material or other depositable conductive material.

An encapsulating body 120 encapsulates the support substrate 102, power integrated circuit device 104, and ring walls 106 which are filled with conductive material to form the package contacts 112. The encapsulating material of the encapsulating body 120 fills spaces between the outside surfaces of the ring walls 106 which contain the package contacts 112. The encapsulating body 120 may, for example, be made of a black resin material that is molded over the structure formed by the support substrate 102, power integrated circuit device 104, ring walls 106 and package contacts 112. The conductive layer 102c at the back surface of the support substrate 102 is exposed at the back side of the encapsulating body 120. Distal ends of the package contacts 112 (and the associated ring walls 106) are exposed at the front side of the encapsulating body 120. The front side of the encapsulating body 120 presents a coplanar front surface for the body 120, distal ends of the ring walls 106 and distal ends of the package contacts 112. This coplanar front surface is the mounting surface for the package 100 (see, Figure 5). In the illustrated configuration with a three-terminal transistor device, the package contact 112 within the ring wall 106 over the conductive layer 102b at the front surface of the substrate 102 provides the drain contact which is electrically coupled to the drain terminal 104a, while the package contacts 112 within the ring walls 106 over the power integrated circuit device 104 provide the source and gate contacts which are electrically coupled to the source terminal 104b and gate terminal 104c, respectively.

Figure 2 shows a cross-sectional view of the power integrated circuit device package 100 where the power integrated circuit device 104 is implemented as a two-terminal device (such as a diode, for example). In this package, the terminal 104a provides a first (for example, cathode) terminal of the diode and the terminal 104b provides a second (for example, anode) terminal of the diode. In the illustrated configuration with a three-terminal transistor device, the package contact 112 within the ring wall 106 over the conductive layer 102b at the front surface of the substrate 102 provides the cathode contact which is electrically coupled to the cathode terminal 102b, while the package contact 112 within the ring wall 106 over the power integrated circuit device 104 provides the anode contact which is electrically coupled to the anode terminal 104b.

It will be noted that the power integrated circuit device package 100 may be configured with more than one power integrated circuit device 104. In such a case, the included power integrated circuit devices 104 are mounted to a common support substrate 102. Package contacts 112 within ring walls 106 are provided for making electrical coupling to each of the device terminals for the included power integrated circuit devices 104.

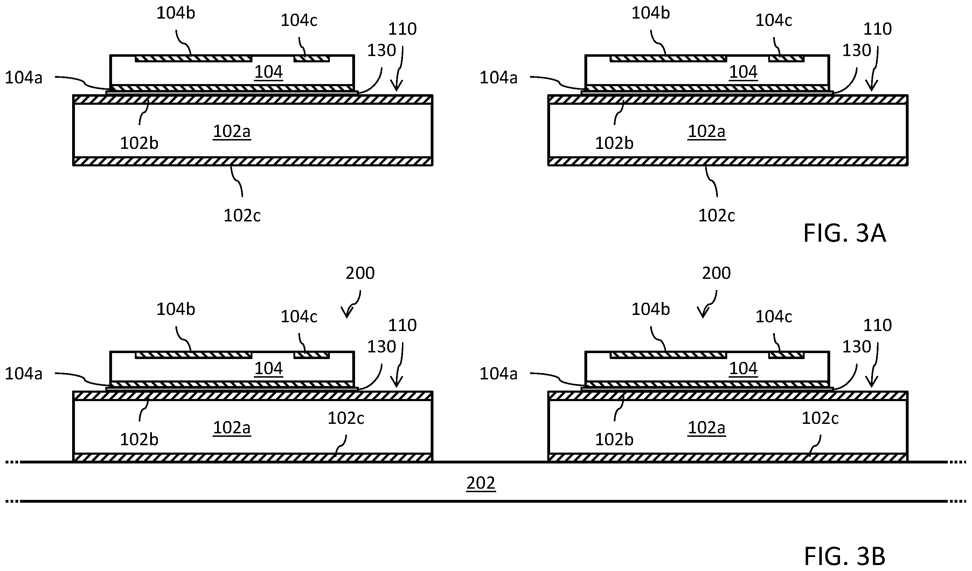

Reference is now made to Figures 3A-3I which show steps of a method of manufacturing the package 100 of Figures 1 and 2.

Figure 3A - power integrated circuit devices 104 are mounted to support substrates 102 using a layer 130 of conductive adhesive material such as, for example, sintering material, soldering material, conductive paste material, etc. The power integrated circuit device 104 may, for example, comprise a MOSFET device, an IGBT device, a GaN device, a diode device, etc. The support substrate 102 may comprise, for example, a direct bond copper (DBC) substrate or an active metal brazing substrate (AMB) substrate.

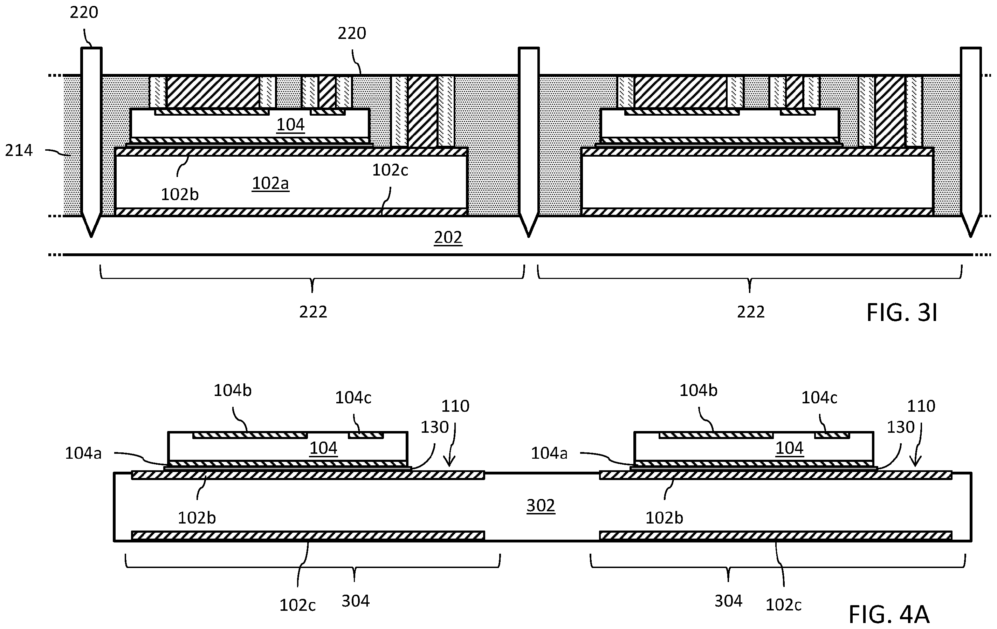

Figure 3B - the assembly 200 of a power integrated circuit device 104 and a support substrate 102 is mounted to a panel carrier 202. This mounting may be made, for example, using a layer of adhesive provided on the top surface of the panel carrier 202. In panel processing, multiple assemblies 200 are mounted to the panel carrier 202 at a corresponding device or package areas (see, reference 222 in Figure 3I).

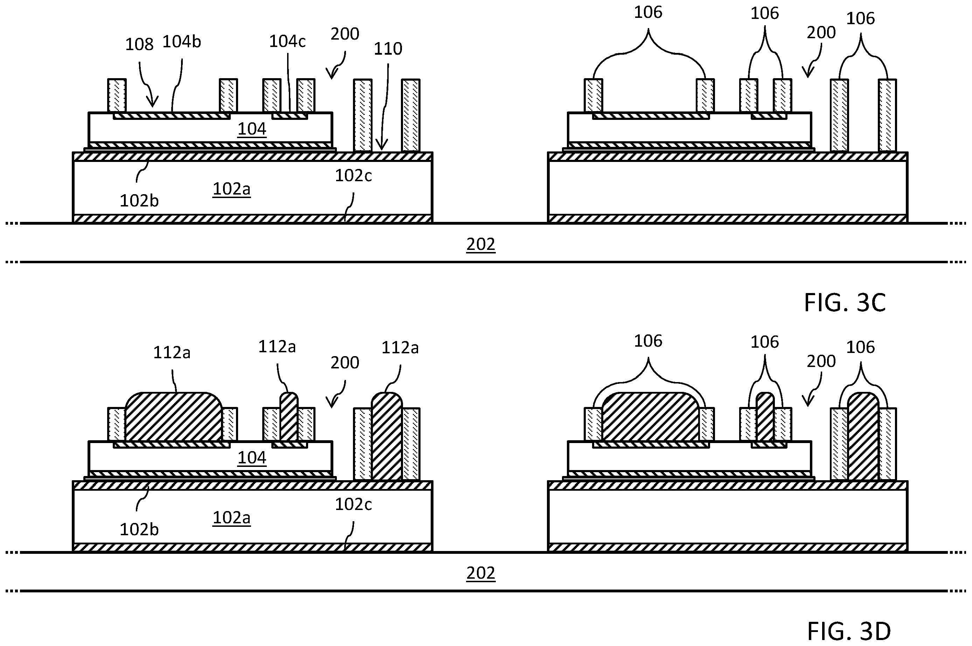

Figure 3C - using a controlled depositing or additive manufacturing operation, ring walls 106 made of insulating material are formed surrounding an area 108 each terminal 104b, 104c at the frontside of the device 104 and surrounding an area 110 of the conductive layer 102b at the front surface of the substrate 102. In an embodiment, the controlled depositing operation may comprise a dispensing operation where the insulating material is dispensed with the desired ring shape. In an embodiment, the controlled depositing operation may comprise a screen printing operating where the insulating material is printed with the desired ring shape. Depositing may further be accomplished using a 3D printing or other additive manufacturing operation. Each ring wall 106 delimits an open top reservoir having a volume over the respective areas 108 and 110.

Figure 3D - using a controlled depositing or additive manufacturing operation, a conductive material 112a is deposited into the volume of each reservoir delimited by the ring walls 106. In an embodiment, the controlled depositing operation may comprise a dispensing operation where the conductive material is dispensed into and completely filling (in an embodiment, over-filling) the volume. In an embodiment, the controlled depositing operation may comprise a screen printing operating where the conductive material is printed into and completely filling (in an embodiment, over-filling) the volume. Depositing may further be accomplished using a 3D printing or other additive manufacturing operation. The conductive material may, for example, comprise a conductive paste, a sintering glue, a hybrid glue, a solder paste, or solder material.

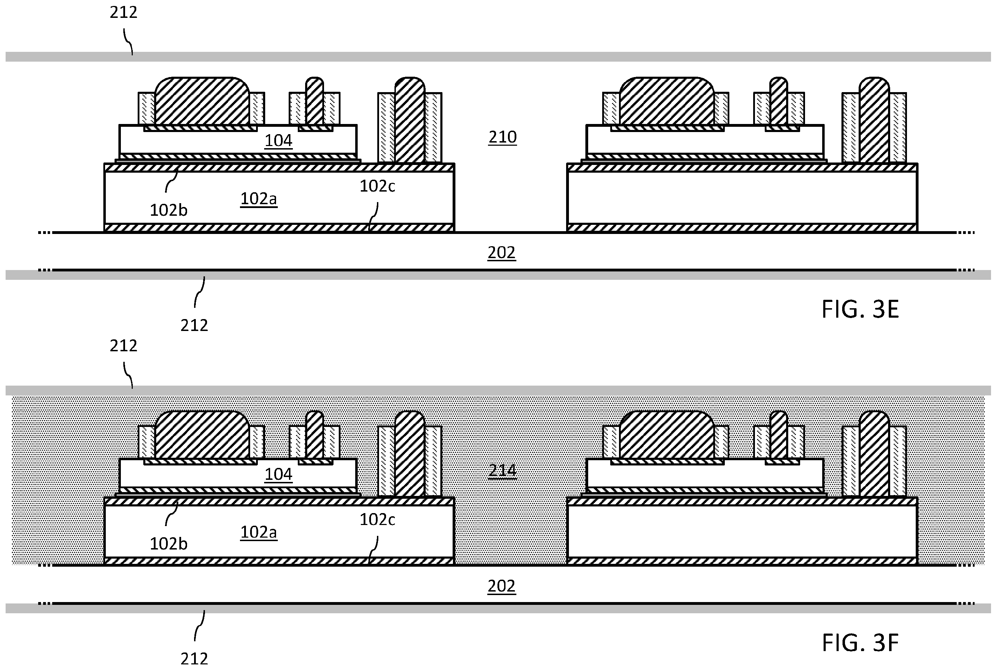

Figure 3E - the panel structure illustrated in Figure 3D is then placed within the cavity 210 of a two-part mold 212.

Figure 3F - an encapsulant material 214 is then injected in the cavity 210 of the mold 212 and allowed to cure. The material 214 encapsulates the assembles 200 with the ring walls 106 and filling conductive material 112a of the Figure 3D panel structure. The encapsulant material 214 may, for example, comprise an opaque resin material.

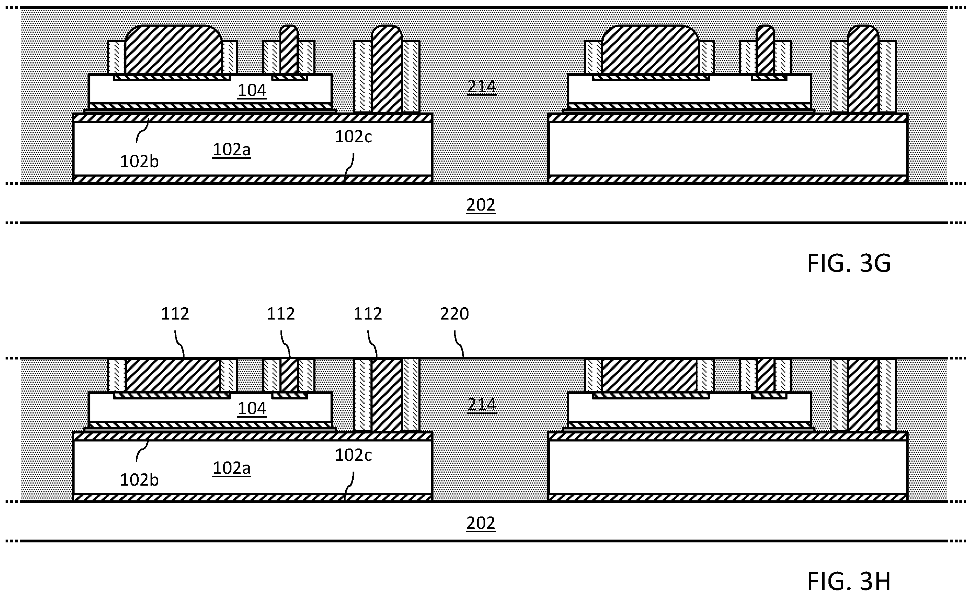

Figure 3G - the molded structure formed in Figure 3F (i.e., an encapsulated panel structure) is then removed from the mold 212.

Figure 3H - a grinding or planarization process is then performed on the molded structure to remove excess encapsulant material 214 and excess conductive material 112a. The grinding operation provides a coplanar top surface 220 for the encapsulant material 214, the ends of the ring walls 106 and the ends of the filling conductive material 112a which form the contacts 112.

Figure 3I - a singulation process using a cutting tool 220 dices the structure of Figure 3H into a plurality of packages 100 (see, Figures 1 and 2) which can then be removed from the panel carrier 202. The cutting tool 220 passes through the encapsulant material 214 in a scribe area located between device or package areas 222. Alternatively, the structure is removed from the panel carrier 202 and then the singulation process is performed by cutting in the scribe areas.

Reference is now made to Figures 4A-4K which show steps of a method of manufacturing the package 100 of Figures 1 and 2.

Figure 4A - a support substrate panel 302 comprising, for example, a direct bond copper (DBC) substrate or an active metal brazing substrate (AMB) substrate, includes a plurality of integrated circuit mounting locations 304. Each location 304 of the panel 302 includes a conductive layer 102b at the front surface and a conductive layer 102c at the back surface. A power integrated circuit device 104 is mounted to the panel 302 at each location 304 using a layer 130 of conductive adhesive material such as, for example, sintering material, soldering material, conductive paste material, etc. The power integrated circuit device 104 may, for example, comprise a MOSFET device, an IGBT device, a GaN device, a diode device, etc.

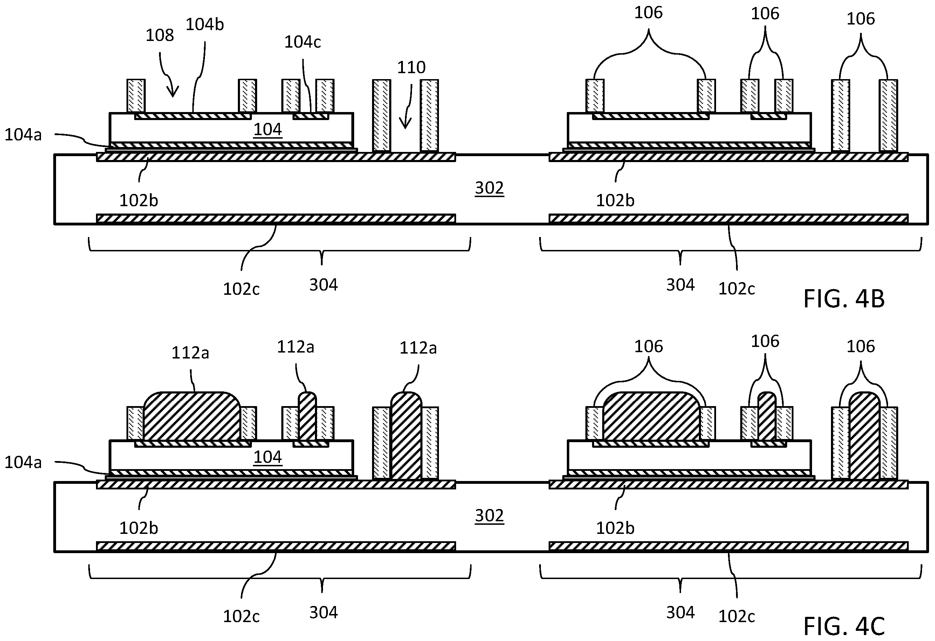

Figure 4B - using a controlled depositing or additive manufacturing operation, ring walls 106 made of insulating material are formed surrounding an area 108 each terminal 104b, 104c at the frontside of the device 104 and surrounding an area 110 of the conductive layer 102b at the front surface of the substrate 102. In an embodiment, the controlled depositing operation may comprise a dispensing operation where the insulating material is dispensed with the desired ring shape. In an embodiment, the controlled depositing operation may comprise a screen printing operating where the insulating material is printed with the desired ring shape. Depositing may further be accomplished using a 3D printing or other additive manufacturing operation. Each ring wall 106 delimits an open top reservoir having a volume over the areas 108 and 110.

Figure 4C - using a controlled depositing or additive manufacturing operation, a conductive material 112a is deposited into the volume of each reservoir delimited by the ring walls 106. In an embodiment, the controlled depositing operation may comprise a dispensing operation where the conductive material is dispensed into and completely filling (in an embodiment, over-filling) the volume. In an embodiment, the controlled depositing operation may comprise a screen printing operating where the conductive material is printed into and completely filling (in an embodiment, over-filling) the volume. Depositing may further be accomplished using a 3D printing or other additive manufacturing operation. The conductive material may, for example, comprise a conductive paste, a sintering glue, a hybrid glue, a solder paste, or solder material.

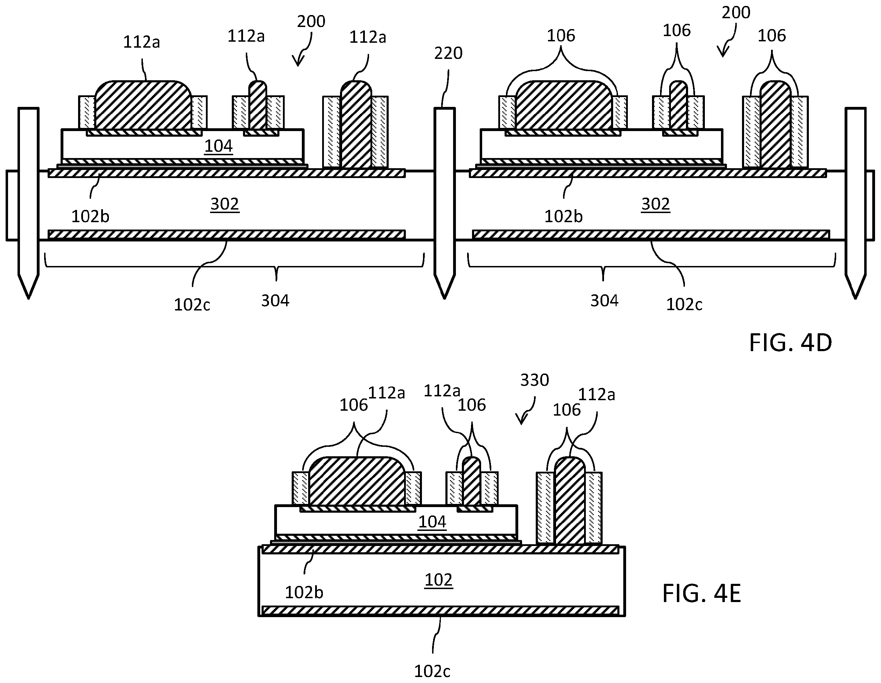

Figure 4D - a singulation process using a cutting tool 310 dices the structure of Figure 4C into a plurality of assemblies 330, wherein each assembly 330 includes a power integrated circuit device 104 and a support substrate 102. One such assembly 330 is shown in Figure 4E. The cutting tool 310 passes through the support substrate panel 302 in a scribe area located between integrated circuit mounting locations 304.

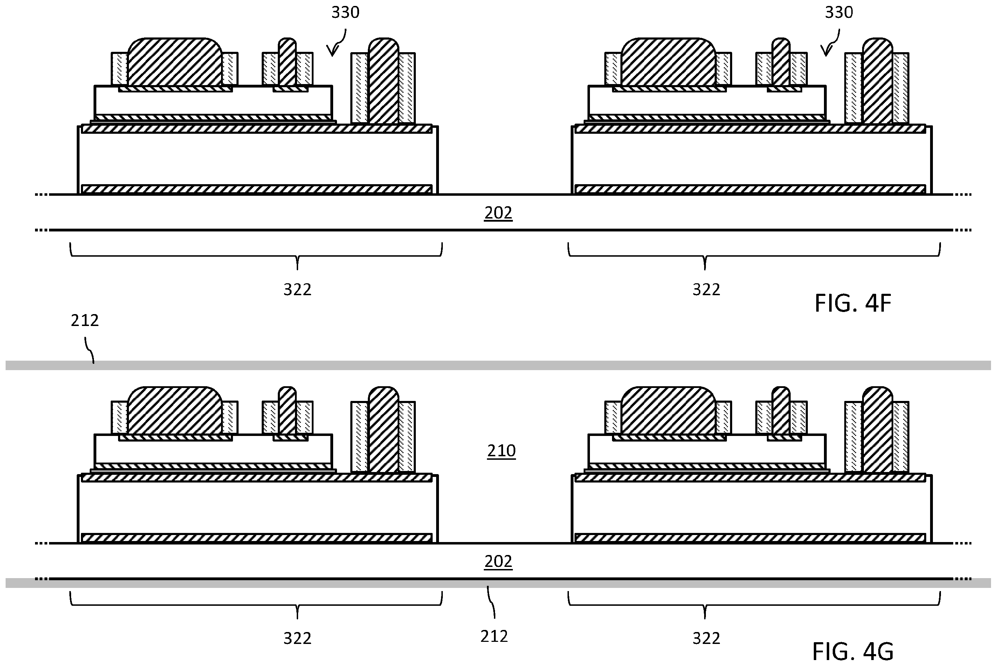

Figure 4F - the assembly 330 of a power integrated circuit device 104 and a support substrate 102 is mounted to a panel carrier 202 at each device or package area 322.

Figure 4G - the panel structure illustrated in Figure 4F is then placed within the cavity 210 of a two-part mold 212.

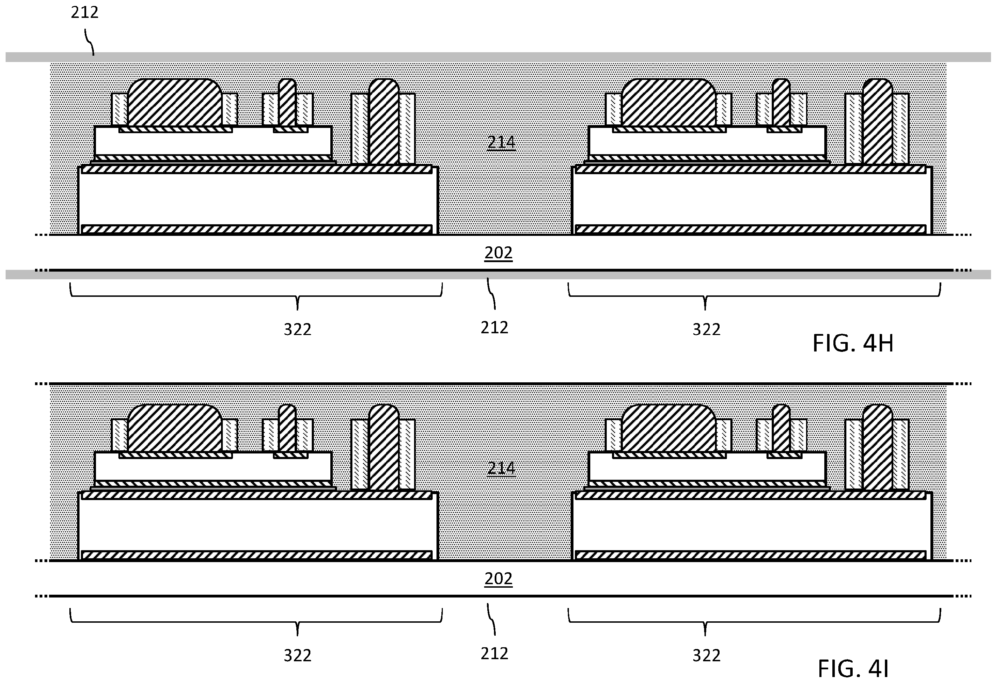

Figure 4H - an encapsulant material 214 is then injected in the cavity 210 of the mold 212 and allowed to cure. The material 214 encapsulates the assembles 200 with the ring walls 106 and filling conductive material 112a of the Figure 4F panel structure. The encapsulant material 214 may, for example, comprise an opaque resin material.

Figure 4I - the molded structure formed in Figure 4H (i.e., the encapsulated panel structure) is then removed from the mold 212.

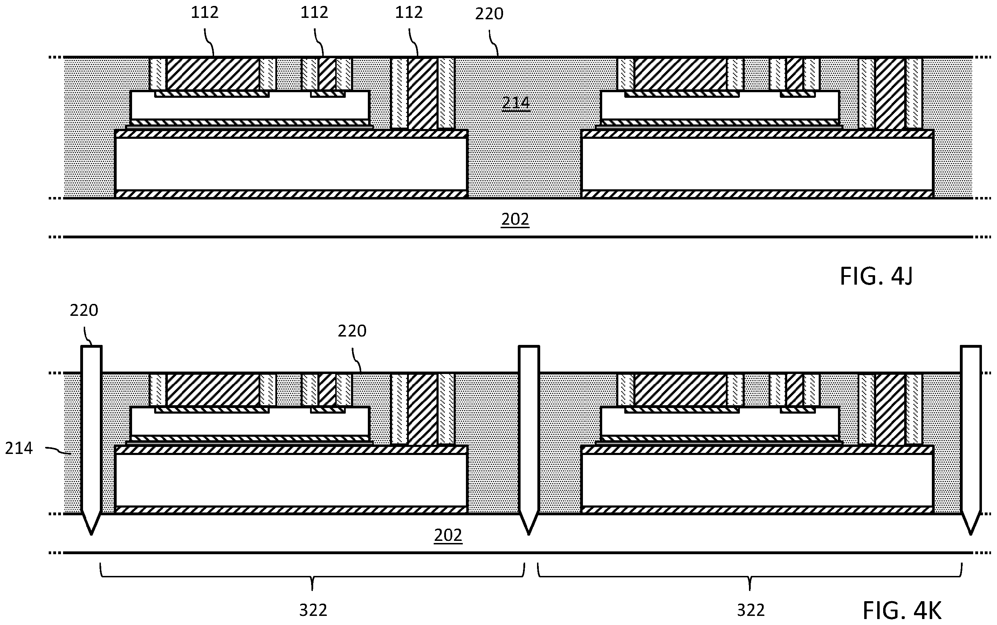

Figure 4J - a grinding or planarization process is then performed to remove excess encapsulant material 214 and excess conductive material 112a to provide a coplanar top surface 220 for the encapsulant material 214, the ring walls 106 and the filling conductive material 112a.

Figure 4K - a singulation process using a cutting tool 220 dices the structure of Figure 4J into a plurality of packages 100 (see, Figures 1 and 2) which can then be removed from the panel carrier 202. The cutting tool 220 passes through the encapsulant material 214 in a scribe area located between package areas 322. Alternatively, the structure is removed from the panel carrier 202 and then the singulation process is performed by cutting at the scribe areas.

Reference is now made to Figure 5 which shows the mounting of the power integrated circuit device package 100 of Figure 1 to a printed circuit board 80. The board 80 include circuit pads 80a and the package contacts 112 are attached to the pads 80a using solder material 80b. A heat dissipator, such as a heatsink 82, may be attached to the conductive layer 102c at the back surface of the substrate 102 for the package 100.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

Example embodiments of the present disclosure are summarized here. The embodiments can also be understood from the entirety of the specification and the examples.

Example 1 : An integrated circuit device package, comprising:
- a support substrate having a front surface with a conductive layer;
- an integrated circuit device having a first device terminal at a backside mounted to the conductive layer of the support substrate and having a second device terminal at a frontside;
- a first insulating ring wall mounted to the conductive layer of the support substrate surrounding an area of the conductive layer;
- a second insulating ring wall mounted to the frontside of the integrated circuit device surrounding an area of the second device terminal;
- metal material filling a volume of a reservoir delimited by each of the first and second insulating ring walls to provide a first package contact for electrical coupling to the first device terminal and a second package contact for electrical coupling to the second device terminal; and
- an encapsulating body which encapsulates the integrated circuit device and the first and second insulating ring walls, wherein a front surface of the encapsulating body is coplanar with distal ends of the first and second insulating ring walls and distal ends of the first and second package contacts.

Example 2 : The integrated circuit device package of example 1, wherein the support substrate is a direct bond copper (DBC) substrate and the integrated circuit device is a power integrated circuit device.

Example 3 : The integrated circuit device package of example 1, wherein the support substrate is an active metal brazing substrate (AMB) substrate and the integrated circuit device is a power integrated circuit device.

Example 4 : The integrated circuit device package of example 1, wherein the integrated circuit device is a power integrated circuit device selected from the group consisting of: a MOSFET device, an IGBT device, a GaN device, a diode device.

Example 5 : The integrated circuit device package of example 1, wherein the first and second insulating ring walls are made of a glue material and wherein the encapsulating body is made of a resin material.

Example 6 : The integrated circuit device package of example 1, wherein the first and second insulating ring walls comprise a controlled deposit material.

Example 7 : The integrated circuit device package of example 1, wherein the first and second insulating ring walls comprise an additive manufacturing material.

Example 8 : The integrated circuit device package of example 1, wherein the first and second insulating ring walls comprise a printed material.

Example 9 : A circuit, comprising:
- a printed circuit board having first and second circuit pads; and
- the integrated circuit device package of example 1 mounted to the printed circuit board with the first and second package contacts soldered to the first and second circuit pads, respectively.

Example 10 : The circuit of example 9, wherein the support substrate of the integrated circuit device package further has a back surface with a further conductive layer, and further comprising a heatsink mounted to the further conductive layer.

Example 11 : A method, comprising:
- mounting an integrated circuit device having a first device terminal at a backside to a conductive layer at a front surface of a support substrate;
- controlling deposit of an insulating material to form a first insulating ring wall at the conductive layer of the support substrate surrounding an area of the conductive layer and form a second insulating ring wall at a frontside of the integrated circuit device surrounding an area of a second device terminal;
- controlling deposit of a conductive material to fill a volume of a reservoir delimited by each of the first and second insulating ring walls to form corresponding first and second contacts electrically coupled to the first and second device terminals, respectively;
- molding an encapsulation material to encapsulate the integrated circuit device and the first and second insulating ring walls within an encapsulating body.

Example 12 : The method of example 11, further comprising grinding the encapsulating material to form a coplanar front surface of the encapsulating body, distal ends of the first and second insulating ring walls and distal ends of the first and second package contacts.

Example 13 : The method of example 11, further comprising cutting through the encapsulating material to singulate an integrated circuit device package.

Example 14 : The method of example 11, wherein the support substrate is a direct bond copper (DBC) substrate and the integrated circuit device is a power integrated circuit device.

Example 15 : The method of example 11, wherein the support substrate is an active metal brazing substrate (AMB) substrate and the integrated circuit device is a power integrated circuit device.

Example 16 : The method of example 11, wherein the integrated circuit device is a power integrated circuit device selected from the group consisting of: a MOSFET device, an IGBT device, a GaN device, a diode device.

Example 17 : The method of example 11, wherein the first and second insulating ring walls are made of a glue material and wherein the encapsulating body is made of a resin material.

Example 18 : The method of example 11, wherein controlling deposit of the insulating material comprises performing a dispensing of the insulating material.

Example 19 : The method of example 11, wherein controlling deposit of the insulating material comprises performing an additive manufacturing of the insulating material.

Example 20 : The method of example 11, wherein controlling deposit of the insulating material comprises performing a printing of the insulating material.

Example 21 : An integrated circuit device package made by the method of example 11.

## Claims

1. An integrated circuit device package, comprising:
- a support substrate having a front surface with a conductive layer;
- an integrated circuit device having a first device terminal at a backside mounted to the conductive layer of the support substrate and having a second device terminal at a frontside;
- a first insulating ring wall mounted to the conductive layer of the support substrate surrounding an area of the conductive layer;
- a second insulating ring wall mounted to the frontside of the integrated circuit device surrounding an area of the second device terminal;
- metal material filling a volume of a reservoir delimited by each of the first and second insulating ring walls to provide a first package contact for electrical coupling to the first device terminal and a second package contact for electrical coupling to the second device terminal; and
- an encapsulating body which encapsulates the integrated circuit device and the first and second insulating ring walls, wherein a front surface of the encapsulating body is coplanar with distal ends of the first and second insulating ring walls and distal ends of the first and second package contacts.

2. A method, comprising:
- mounting an integrated circuit device having a first device terminal at a backside to a conductive layer at a front surface of a support substrate;
- controlling deposit of an insulating material to form a first insulating ring wall at the conductive layer of the support substrate surrounding an area of the conductive layer and form a second insulating ring wall at a frontside of the integrated circuit device surrounding an area of a second device terminal;
- controlling deposit of a conductive material to fill a volume of a reservoir delimited by each of the first and second insulating ring walls to form corresponding first and second contacts electrically coupled to the first and second device terminals, respectively;
- molding an encapsulation material to encapsulate the integrated circuit device and the first and second insulating ring walls within an encapsulating body.

3. The integrated circuit device package of claim 1, or the method of claim 2, wherein the support substrate is a direct bond copper (DBC) substrate and the integrated circuit device is a power integrated circuit device.

4. The integrated circuit device package of claim 1, or the method of claim 2, wherein the support substrate is an active metal brazing substrate (AMB) substrate and the integrated circuit device is a power integrated circuit device.

5. The integrated circuit device package of any one of claims 1, 3 or 4, or the method of any one of claims 2 to 4, wherein the integrated circuit device is a power integrated circuit device selected from the group consisting of: a MOSFET device, an IGBT device, a GaN device, a diode device.

6. The integrated circuit device package of any one of claims 1, 3 to 5, or the method of any one of claims 2 to 5, wherein the first and second insulating ring walls are made of a glue material and wherein the encapsulating body is made of a resin material.

7. The integrated circuit device package of any one of claims 1, 3 to 6, wherein the first and second insulating ring walls comprise a controlled deposit material, or the method of any one of claims 2 to 6, wherein controlling deposit of the insulating material comprises performing a dispensing of the insulating material.

8. The integrated circuit device package of any one of claims 1, 3 to 7, wherein the first and second insulating ring walls comprise, or the method of any one of claims 2 to 7, wherein controlling deposit of the insulating material comprises performing an additive manufacturing material.

9. The integrated circuit device package of any one of claims 1, 3 to 8, wherein the first and second insulating ring walls comprise a printed material, or the method of any one of claims 2 to 8, wherein controlling deposit of the insulating material comprises performing a printing of the insulating material.

10. The method of any one of claims 2 to 9, further comprising grinding the encapsulating material to form a coplanar front surface of the encapsulating body, distal ends of the first and second insulating ring walls and distal ends of the first and second package contacts.

11. The method of any one of claims 2 to 10, further comprising cutting through the encapsulating material to singulate an integrated circuit device package.

12. An integrated circuit device package made by the method of any one of claims 2 to 11.

13. A circuit, comprising:
- a printed circuit board having first and second circuit pads; and
- the integrated circuit device package of any one of claims 1, 3 to 9 mounted to the printed circuit board with the first and second package contacts soldered to the first and second circuit pads, respectively.

14. The circuit of claim 13, wherein the support substrate of the integrated circuit device package further has a back surface with a further conductive layer, and further comprising a heatsink mounted to the further conductive layer.
